(19) Europäisches Patentamt

European Patent Office

Office européen des brevets

(11) **EP 0 506 577 B1**

(12) **FASCICULE DE BREVET EUROPEEN**

(45) Date de publication et mention
de la délivrance du brevet:
**13.05.1998 Bulletin 1998/20**

(51) Int Cl.⁶: **G06F 12/02**, G11C 7/00,
G06F 12/06

(21) Numéro de dépôt: **92400861.8**

(22) Date de dépôt: **27.03.1992**

(54) **Circuit de gestion de nombres d'accès à des ressources logiques**

Schaltung zum verwalten von logischen Betriebsmittelnzugriffszahlen

Circuit for managing logical resource access numbers

(84) Etats contractants désignés:
**DE ES GB IT SE**

(30) Priorité: **29.03.1991 FR 9103815**

(43) Date de publication de la demande:
**30.09.1992 Bulletin 1992/40**

(73) Titulaire: **FRANCE TELECOM**
**75015 Paris (FR)**

(72) Inventeurs:
- **Majos, Jacques**
  **F-38420 Le Versoud (FR)**
- **Andre, Alain**
  **F-38190 Crolles (FR)**
- **Teyssier, Henri**
  **F-38330 St Ismier (FR)**

(74) Mandataire: **Cabinet Martinet & Lapoux**
**BP 405**
**78055 Saint Quentin en Yvelines Cédex (FR)**

(56) Documents cités:
**EP-A- 0 298 793**          **EP-A- 0 300 876**
**FR-A- 2 309 011**

- **PATENT ABSTRACTS OF JAPAN vol. 7, no. 117
(P-198)21 Mai 1983 & JP-A-58 037 755**
- **IBM TECHNICAL DISCLOSURE BULLETIN. vol.
32, no. 8A, Janvier 1990, NEW YORK US pages
418-421; 'High Speed Buffer for Nx1 Packet
Multiplexing'**

## Description

La présente invention concerne un circuit de gestion de nombres d'accès à des ressources logiques pour établir des adresses d'écriture de ressources disponibles dans un ensemble de ressources logiques en fonction des nombres d'accès mis à jour, le nombre d'accès attribué à une ressource logique étant décrémenté d'une unité en réponse à une adresse de lecture de ladite ressource.

Par exemple, les ressources logiques sont des cellules de données d'une mémoire-tampon qui est mise en oeuvre dans un système de commutation temporelle et dans laquelle sont écrites des données reçues aléatoirement.

La demande de brevet EP-A-0300876 divulgue un système de commutation de blocs de données entre plusieurs voies multiplex à division du temps entrantes et plusieurs voies multiplex à division du temps sortantes. Les blocs dans chacune des voies multiplex peuvent être des blocs synchrones en mode-circuit et/ou des blocs asynchrones en mode-paquet, et ont une longueur constante.

En particulier, les blocs asynchrones d'une même communication sont transmis sporadiquement dans les voies multiplex.

Tous les blocs de données sont écrits au fur et à mesure de leur réception dans une mémoire-tampon et sont lus une ou plusieurs fois dans la mémoire-tampon pour être diffusés vers une ou plusieurs voies multiplex sortantes. En effet, la communication relative à des blocs de données dans une voie entrante peut être une communication point-à-point ou une communication multipoint. Pour une communication multipoint, un bloc de données doit être lu dans la mémoire-tampon autant de fois qu'il y a de voies multiplex sortantes destinataires devant recevoir le bloc de données. La cellule de mémoire-tampon dans laquelle est écrit un bloc de données, doit être libérée lors de la dernière lecture du bloc.

Au sens de la présente invention, les ressources logiques peuvent être ainsi des cellules de bloc de données de la mémoire tampon, et le nombre d'accès à une ressource désigne le nombre de lectures ou le nombre de voies multiplex sortantes vers lesquelles doit être diffusé un bloc de données mémorisé dans la ressource.

Sachant que d'une part, les blocs de données sont écrits sporadiquement dans la mémoire-tampon, d'autre part un bloc de données doit demeurer en mémoire-tampon pendant plusieurs cycles de lecture pour être diffusé, la EP-A-0300876 propose un circuit de gestion de nombres d'accès, appelé "circuit de gestion de mémoire-tampon et d'adressage en écriture" afin d'optimiser la capacité de la mémoire-tampon tout en gérant, c'est-à-dire mettant à jour les nombres d'accès au fur et à mesure des diffusions des blocs de données.

Ce circuit de gestion est organisé essentiellement autour de deux mémoires, chaque mémoire contenant des cellules respectivement associées à celles de la mémoire-tampon.

Une première mémoire, appelée "mémoire de libération de cellule", mémorise les nombres d'accès mis à jour. Initialement, lorsqu'un bloc de données est écrit, une cellule de la première mémoire enregistre le nombre d'accès vers lesquels le bloc doit être transmis, puis chaque fois que ce bloc est lu, le nombre d'accès est décrémenté d'une unité jusqu'à atteindre zéro afin de libérer la cellule associée dans la mémoire-tampon pour l'écriture d'un autre bloc.

Pour mettre à jour chaque nombre d'accès, les sorties et entrées de données de la première mémoire sont reliées à travers un circuit de décrémentation et un circuit de test à zéro, et la première mémoire est associée à d'autres multiplexeurs et portes logiques pour son adressage en écriture et lecture en fonction des instants d'écriture et de lecture des cellules de mémoire-tampon notamment.

La seconde mémoire, appelée "mémoire d'adresse de cellule disponible", constitue un circuit pour mémoriser des états de disponibilité de ressources logiques, c'est-à-dire des états de cellule de bloc dans la mémoire-tampon, et pour établir des adresses de cellules libres. Ce circuit est décrit dans la demande de brevet EP-A-0298793. La seconde mémoire comprend essentiellement une matrice de cellules à un bit, et un circuit de codage d'adresse de cellule de mémoire-tampon. Les cellules de la matrice sont respectivement assignées aux cellules de bloc de la mémoire tampon.

Chaque cellule de la matrice mémorise un bit d'état de disponibilité de la cellule respective de la mémoire-tampon. Le bit d'état est à l'état haut "1" lorsque la cellule de mémoire-tampon est libre et donc prête à enregistrer un bloc de données d'une voie multiplex entrante. Le bit d'état est à l'état bas "0" lorque la cellule de la mémoire-tampon est occupée par un bloc de données écrit qui doit être lu une ou plusieurs fois en fonction du nombre d'accès respectif mis à jour, mémorisé dans la première mémoire. Le circuit de codage dans la seconde mémoire est relié aux sorties de toutes les cellules de la matrice afin de sélectionner l'une des cellules de la matrice ayant un bit d'état "1", selon un ordre de priorité de cellule prédeterminé, et ainsi établir en permanence l'adresse d'une cellule de matrice libre sélectionnée égale à l'adresse d'écriture de la cellule de bloc respective dans la mémoire-tampon.

Outre le circuit de décrémentation et le circuit de test à zéro, d'autres moyens logiques entre la sortie de données de la première mémoire et l'entrée de données de la seconde mémoire sont prévus dans le circuit de gestion afin de modifier les bits d'état dans la seconde mémoire. En effet, lors de la lecture d'un bloc de données, seule la cellule correspondante dans la première mémoire est adressée en lecture et écriture pour décrémenter le nombre d'accès d'une unité tant que celui-ci est différent de zéro, le bit à l'état bas dans la cellule correspondante de la seconde mémoire n'étant pas modifiée. Par contre, lorsque le nombre d'accès atteint zéro, suite à la dernière lecture de bloc de données, le circuit de décrémentation demande la modification du bit d'état dans la seconde mémoire.

La séparation matérielle de la mise à jour des nombres d'accès effectuée essentiellement par la première mémoire et de la surveillance des états de disponibilité des ressources logiques effectuée par la seconde mémoire est ainsi contraignante tant du point de vue de la durée pour effectuer ces opérations qui dépendent des nombreux circuits mis en oeuvre, que tant du point de vue de l'encombrement des divers circuits et mémoires.

L'invention est définie dans la revendication 1.

La présente invention vise à améliorer la vitesse de fonctionnement et la compacité d'un circuit de gestion de nombres d'accès à des ressources logiques, et corollairement à réduire le coût de fabrication d'un tel circuit. Plus précisément, l'invention propose de combiner fonctionnellement et matériellement les première et seconde mémoire dans le circuit connu en un unique circuit matriciel de cellules.

A cette fin, un circuit de gestion de nombres d'accès à des ressources logiques tel que défini dans l'entrée en matière, est caractérisé en ce qu'il comprend :

- une matrice incluant des cellules de comptage qui mémorisent respectivement les nombres d'accès mis à jour des ressources de l'ensemble,
- des moyens, de sélection de cellule pour sélectionner l'une des cellules de comptage contenant des nombres d'accès égaux à zéro afin d'établir l'adresse d'écriture de la ressource disponible associée à la cellule sélectionnée, et charger un nombre d'accès de la ressource disponible dans la cellule sélectionnée, et
- des moyens de décodage d'adresse de lecture de ressource pour décrémenter d'une unité les nombres d'accès différents de zéro dans des cellules de comptage en réponse aux adresses de lecture de ressource respectivement.

Ainsi, la matrice de cellule de comptage sert à la fois pour la surveillance de la disponibilité des ressources logiques et pour la mise à jour des nombres d'accès.

S'agissant de la surveillance des ressources afin de sélectionner une ressource libre, les moyens de sélection comprennent, de préférence, des premiers moyens pour sélectionner parmi toutes les lignes de la matrice des lignes de matrice ayant chacune au moins une cellule de comptage contenant un nombre d'accès égal à zéro afin d'établir l'adresse de l'une des lignes sélectionnées, et des seconds moyens pour sélectionner parmi toutes les colonnes de la matrice, des colonnes de matrice comprenant des cellules de comptage qui contiennent des nombres d'accès égaux à zéro et qui sont incluses dans la ligne sélectionnée dont l'adresse est établie afin d'établir l'adresse de l'une des colonnes sélectionnées et charger un nombre d'accès dans la cellule de comptage correspondant aux adresses établies de la ligne sélectionnée et de la colonne sélectionnée.

S'agissant de la mise à jour des ressources, les moyens de décodage d'adresse de lecture comprennent, de préférence, des moyens pour préparer la décrémentation des cellules de comptage dans une ligne de la matrice en réponse à une adresse de ligne incluse dans une adresse de lecture, et des moyens pour décrémenter d'une unité une cellule de comptage préparée en réponse à une adresse de colonne incluse dans l'adresse de lecture, la décrémentation de ladite cellule de comptage étant de préférence simultanée au chargement de nombre d'accès dans une autre cellule de comptage par les moyens de sélection de cellule.

Selon une réalisation préférée, chaque cellule de comptage comprend un compteur synchrone à séquence pseudoaléatoire. La séquence est composée de mots codés respectivement associés à des nombres d'accès décroissants différents, inférieurs à un nombre maximal. La sortie du compteur comprend un moyen pour signaler aux moyens de sélection de cellule un nombre d'accès nul contenu dans la cellule lorsque le dernier mot de la séquence est contenu dans le compteur.

D'autres caractéristiques et avantages de la présente invention apparaîtront plus clairement à la lecture de la description suivante de réalisations préférées de l'invention en référence aux dessins annexés correspondants dans lesquels :

- la Fig. 1 est un bloc-diagramme d'un circuit de gestion de nombres d'accès selon l'invention, comprenant une matrice de cellules de comptage;
- la Fig. 2 montre en détail l'une des cellules de comptage incluse dans la matrice de cellules de comptage; et
- la Fig. 3 montre en détail un compteur inclus dans une cellule de comptage.

Dans la réalisation décrite ci-après, il est supposé qu'un circuit de gestion selon l'invention est destiné à commander les accès à des ressources logiques consistant par exemple en des cellules de données d'une mémoire-tampon incorporée dans un système de commutation temporelle de données asynchrones et/ou synchrones du type défini dans la EP-A-0300876. La mémoire-tampon est constituée de cellules de données qui sont organisées en une matrice ayant $I = 32$ colonnes et $J = 16$ lignes et qui mémorisent 1024 octets transmis par seize voies multiplex entrantes parallèles. Chaque voie multiplex entrante transmet des trames de 32 blocs de données environ précédées par un mot de verrouillage de trame. Chaque bloc de données comporte seize octets qui sont transmis ultérieurement vers une ou plusieurs voies multiplex sortantes respectives en tant qu'accès de ressource logique relatif à la cellule de données ayant mémorisée le premier octet, dit étiquette, du bloc de données. Un bloc de données peut être composé, soit de données en mode-paquet, c'est-à-dire d'un paquet asynchrone, soit de données en mode-circuit, c'est-à-dire un ensemble de seize octets consécutifs d'un canal de parole numérisée par exemple. Chaque cellule de la mémoire de données est propre à mémoriser huit bits.

Il est à noter qu'un circuit de gestion selon l'invention peut également être utilisé dans un contexte plus général de gestion dynamique de ressources logiques telles que par exemple des mémoires-tampons dans des interfaces.

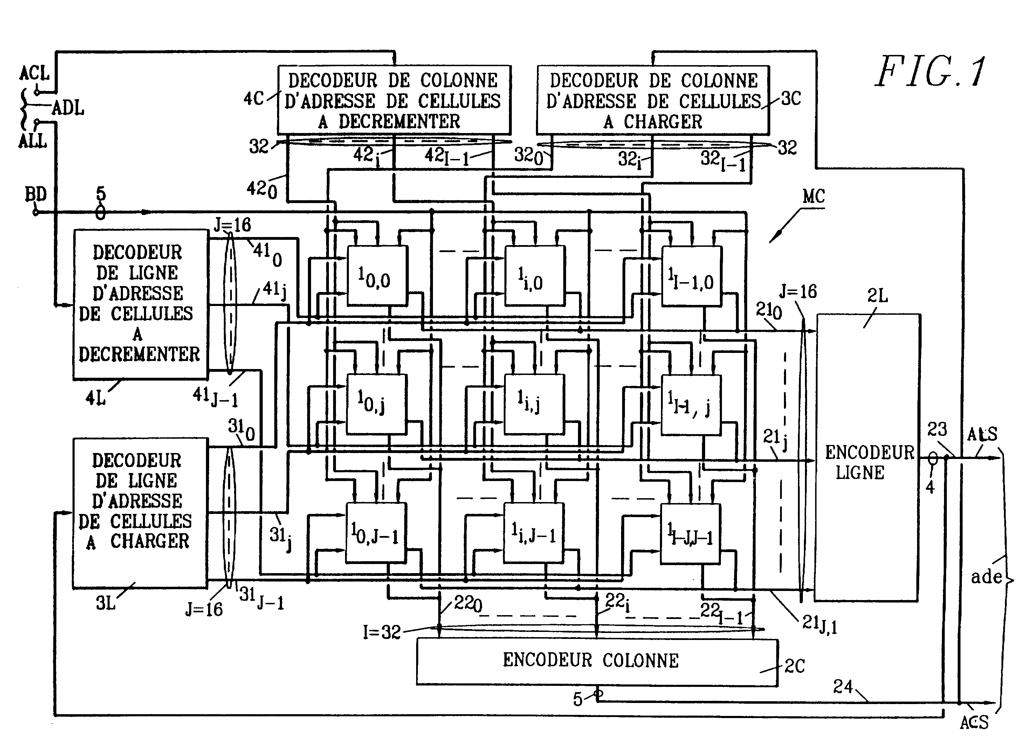

En référence à la Fig. 1, le circuit de gestion de nombres d'accès à des ressources logiques selon l'invention est structuré autour d'une matrice MC comportant $I = 32$ colonnes et $J = 16$ lignes de cellules de comptage identiques $1_{0,0}$ à $1_{I-1,J-1} = 1_{31,15}$. Chaque cellule de comptage $1_{i,j}$, où i est un indice entier compris entre 0 et $I-1 = 31$ et j est un indice entier compris entre O et $J-1 = 15$, mémorise le nombre instantané d'accès $NB_{i,j}$ relatif à une cellule de données correspondante de la mémoire-tampon.

Le nombre d'accès $NB_{i,j}$ est égal au nombre de voies multiplex sortantes vers lesquelles le bloc de données mémorisé en mémoire-tampon et dont l'étiquette est mémorisée dans la cellule de données correspondante doit être encore diffusé. Lorsque le bloc de données est reçu et écrit en mémoire-tampon, le nombre $NB_{i,j}$ est maximum et égal au nombre de voies multiplex sortantes auxquelles le bloc de données est destiné. Puis, à chaque lecture du bloc de données, le nombre $NB_{i,j}$ est décrémenté d'une unité. Chaque lecture peut intervenir au plus après transmission de 16 blocs de données dans les 16 voies sortantes respectivement. Lorsque le bloc de données a été lu et transmis vers les $NB_{i,j}$ voies multiplex sortantes correspondantes, le nombre $NB_{i,j}$ est égal à zéro.

Selon la réalisation illustrée, lorsque le nombre $NB_{i,j}$ est différent de zéro, la sortie de la cellule de comptage $1_{i,j}$ est à l'état "0" ce qui indique que de la cellule de données est occupée par des données et donc est indisponible pour écrire des données. Au contraire, lorsque le nombre $NB_{i,j}$ est égal à zéro, c'est-à-dire après la dernière lecture du bloc de données correspondant en mémoire-tampon, la sortie de la cellule de comptage $1_{i,j}$ est à l'état "1". Cet état "1" traduit la disponibilité de la cellule de données pour y écrire des données, telles qu'une étiquette, relatives à un autre bloc de données transmis par l'une des voies multiplex entrantes.

Outre la matrice de cellules de comptage MC, le circuit de gestion comprend un couple d'encodeurs 2L et 2C, un premier couple de décodeurs 3L et 3C, et un second couple de décodeurs 4L et 4C. Dans chacun des trois couples, l'un des éléments, tels que l'encodeur 2L, le décodeur 3L et le décodeur 4L, est relatif à des adresses de ligne de la matrice MC, et l'autre des éléments, tels que l'encodeur 2C, le décodeur 3C et le décodeur 4C, est relatif à des adresses de colonne de la matrice MC.

Les encodeurs 2L et 2C offrent respectivement $J = 16$ entrées $21_O$ à $21_{J-1}$ et $I = 32$ entrées $22_O$ à $22_{I-1}$. Une entrée $21_j$ de l'encodeur 2L est reliée à des sorties de lecture de ligne des cellules $1_{O,j}$ à $1_{I-1,j}$ dans la ligne de rang j de la matrice MC. De même, une entrée $22_i$ de l'encodeur 2C est reliée à des sorties de lecture de colonne des cellules $1_{i,O}$ à $1_{i,J-1}$ dans la colonne de rang i de la matrice MC.

Comme on le verra dans la suite, la recherche d'une cellule de comptage dans la matrice MC s'effectue d'abord ligne par ligne en réponse à un signal de commande de lecture de ligne CL, puis colonne par colonne en réponse à un signal de commande de lecture de colonne CC. Lorsqu'au moins l'une des cellules dans la ligne de rang j, respectivement dans la colonne de rang i, est disponible, la sortie de lecture de ligne, respectivement de colonne, de la cellule est à l'état "1" ce qui impose l'état "1" à l'entrée $21_j$ de l'encodeur 2L, respectivement $22_i$ de l'encodeur 2C. Par contre, lorsque toutes les cellules dans une ligne ou colonne contiennent des nombres d'accès différents de zéro, c'est-à-dire ont leur sortie à l'état "0", l'entrée correspondante de l'encodeur 2L ou 2C est à l'état "0". Ainsi, les liaisons entre sorties des cellules dans une même ligne ou colonne de la matrice sont équivalentes à des OU câblés.

La sélection d'une ligne ou d'une colonne comprenant une cellule de comptage libre dans l'encodeur 2L ou 2C s'effectue selon un ordre de priorité prédéterminé. On se référera dans la suite, à titre d'exemple, à l'ordre de priorité suivant. Sachant que les lignes et colonnes sont numérotées par ordre croissant 0 à $J-1$ et 0 à $I-1$, l'encodeur 2L sélectionne la ligne comprenant une cellule disponible et ayant le plus petit rang, et l'encodeur 2C sélectionne la colonne comprenant une cellule disponible et ayant le plus petit rang. Ainsi, l'encodeur 2L produit le rang de la ligne sélectionnée sous la forme d'une adresse ALS à $\log_2 J = 4$ bits parallèles dans un bus de sortie 23, et l'encodeur 2C produit le rang de la colonne sélectionnée sous la forme d'une adresse ACS à $\log_2 I = 5$ bits parallèles dans un bus de sortie 24. Les deux adresses ALS et ACS constituent une adresse d'une cellule de comptage disponible sélectionnée, qui est égale à l'adresse d'écriture ade de la cellule de données correspondante en mémoire-tampon.

Les décodeurs 3L et 3C sont destinés à charger le nombre d'accès dans une cellule de comptage disponible sélectionnée, lors de l'arrivée d'un bloc de données.

Les décodeurs 3L et 3C présentent respectivement $J = 16$ sorties $31_0$ à $31_{J-1}$ et $I = 32$ sorties $32_0$ à $32_{I-1}$. Une sortie $31_j$ du décodeur 3L est reliée à des premières entrées de chargement $CHL_{O,j}$ à $CHL_{I-1,j}$ des cellules $1_{O,j}$ à $1_{I-1,j}$ dans la ligne de rang j de la matrice MC. De même, une sortie $32_i$ du décodeur 3C est reliée à des secondes entrées de chargement $CHC_{i,O}$ à $CHC_{i,J-1}$ des cellules $1_{i,O}$ à $1_{i,J-1}$ dans la colonne de rang i de la matrice MC. Les décodeurs 3L et 3C ont également des entrées parallèles reliées respectivement aux bus 23 et 24 afin de décoder les adresses de ligne et de colonne d'une cellule de comptage disponible de manière à activer les entrées de chargement de cette cellule par des états "1".

Les seconds décodeurs 4L et 4C sont destinés à décrémenter d'une unité le nombre d'accès dans une cellule de comptage chaque fois que le bloc de données correspondant mémorisé dans la mémoire-tampon doit être transmis vers un accès ou voie multiplex sortante. Cette décrémentation est autorisée ainsi chaque fois que l'étiquette de ce bloc de données doit être lue dans la cellule de données correspondante, en réponse à une adresse de lecture ADL de la cellule de données établie par le circuit de commande et d'adressage en lecture inclus dans le système de commutation. L'adresse de lecture ADL est en fait composée d'une adresse de ligne à 4 bits ALL appliquée au décodeur 4L et d'une adresse de colonne à 5 bits ACL appliquée au décodeur 4C.

Comme les décodeurs 3L et 3C, les décodeurs 4L et 4C présentent $J = 16$ sorties $41_O$ à $41_{J-1}$ et $I = 32$ sorties $42_O$ à $42_{I-1}$. Une sortie $41_j$ du décodeur 4L est reliée à des premières entrées de décrémentation $DL_{O,j}$ à $DL_{I-1}$ des cellules $1_{O,j}$ à $1_{I-1,j}$ dans la ligne de rang j de la matrice MC. La sortie $41_j$ est à l'état "1" lorsque l'adresse ALL est égale à j en code binaire. De même, une sortie $42_i$ du décodeur 4C est reliée à des secondes entrées de décrémentation $DC_{i,O}$ à $DC_{i,J-1}$ des cellules $1_{i,O}$ à $1_{i,J-1}$ dans la colonne de rang i de la matrice MC. La sortie $42_i$ est à l'état "1" lorsque l'adresse ACL est égale à i en code binaire.

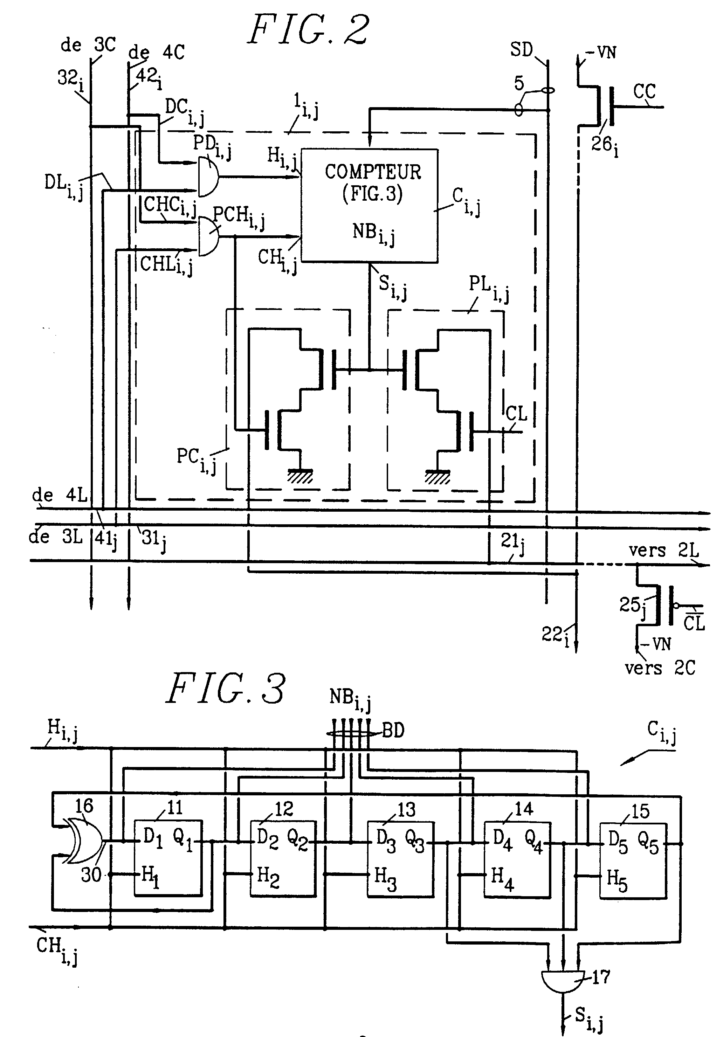

En référence à la Fig. 2, une cellule de comptage $1_{i,j}$ comprend un compteur $C_{i,j}$, deux portes NAND à deux entrées $PL_{i,j}$ et $PC_{i,j}$ et deux portes ET à deux entrée $PCH_{i,j}$ et $PD_{i,j}$.

Les portes $PL_{i,j}$ et $PC_{i,j}$ ont des premières entrées reliées à une sortie $S_{i,j}$ du compteur $C_{i,j}$. La sortie $S_{i,j}$ est à l'état "0" lorsque le nombre d'accès $NB_{i,j}$ correspondant au compte mis à jour dans le compteur est différent de zéro, c'est-à-dire lorsque la cellule $1_{i,j}$ est indisponible. En pratique, comme illustré à la Fig.2, les portes NAND $PL_{i,j}$ et $PC_{i,j}$ sont réalisées chacune au moyen de premier et second transistors MOS et d'un transistor MOS de charge respectif $25_j$, $26_i$. Le drain du premier transistor MOS est relié à la source du second transistor MOS, et la source du premier transistor est à la masse, dans chacune des portes $PL_{i,j}$ et $PC_{i,j}$. Tous les transistors de chacune des portes $PL_{i,j}$ et $PC_{i,j}$ sont de type à canal P.

La première porte $PL_{i,j}$ est destinée à transférer l'état "1" à la sortie $S_{i,j}$ du compteur $C_{i,j}$ qui correspond à l'état libre de la cellule vers l'entrée de ligne $21_j$ de l'encodeur 2L en réponse au premier signal de commande de lecture CL à l'état haut "1". La grille du premier transistor reçoit le signal CL tandis que la grille du second transistor est reliée à la sortie de compteur $S_{i,j}$ dans la porte $PL_{i,j}$. Le transistor de charge $25_j$ est commun à toutes les cellules $1_{O,j}$ à $1_{I-1,j}$ de la ligne de rang j dans la matrice MC et est localisé à l'entrée de l'encodeur 2L. La grille du transistor $25_j$ reçoit le premier signal de commande complémentaire $\overline{CL}$, la source de ce transistor est reliée à l'entrée $21_j$ et le drain de ce transistor est porté à une tension de polarisation négative -VN. Ainsi lorsque CL = "1" et $S_{i,j}$ = "1", l'état de la sortie $S_{i,j}$ du compteur $C_{i,j}$ est reportée à l'entrée $21_j$ de l'encodeur 2L, quels que soient les états des sorties des autres compteurs $C_{O,j}$ à $C_{I-1,j}$ dans la ligne de rang j. L'entrée $21_j$ passe à l'état "0" seulement lorsque toutes les sorties des compteurs $C_{O,j}$ à $C_{I-1,j}$ sont à l'état "0", c'est-à-dire lorsque toutes les cellules de comptage $1_{O,j}$ à $1_{I-1,j}$ contiennent des nombres d'accès $NB_{O,j}$ à $NB_{I-1,j}$ différents de zéro.

La seconde porte $PC_{i,j}$ est destinée à transférer l'état "1" à la sortie $S_{i,j}$ du compteur $C_{i,j}$ vers l'entrée de colonne de l'encodeur 2C en réponse au second signal de commande CC, lorsque la sortie $31_j$ du décodeur 3L est à l'état "1" suite à la sélection de la ligne de rang j par l'encodeur 2L. Dans la porte $PC_{i,j}$, les grilles des premier et second transistors sont reliées respectivement à la sortie $S_{i,j}$ du compteur $C_{i,j}$ et la sortie $31_j$ du décodeur 3L. Le transistor de charge $26_i$ est commun à toutes les cellules $1_{i,O}$ à $1_{i,J-1}$ de la ligne de rang i dans la matrice MC et est localisé à l'entrée de l'encodeur 2C. Relativement à ce transistor $26_i$, d'une manière analogue au transistor $25_j$, la grille reçoit le second signal de commande CC, la source est reliée à l'entrée $22_i$ et le drain est porté à la tension négative -VN. Le fonctionnement de la porte $PC_{i,j}$ est analogue à celui de la porte $PL_{i,j}$. En particulier, lorsque les sorties $S_{i,j}$ et $31_j$ sont à l'état "1", l'état de l'entrée $22_i$ de l'encodeur 2C est à l'état de disponibilité "1" quels que soient les états des entrées des autres compteurs $C_{i,O}$ à $C_{i,J-1}$ dans la colonne de rang i.

Les entrées de la porte $PCH_{i,j}$ sont reliées respectivement à la sortie $31_j$ du décodeur 3L et à la sortie $32_i$ du décodeur 3C. Lorsque les entrées de la porte $PCH_{i,j}$ sont portées à l'état "1", la sortie de la porte $PCH_{i,j}$ commande par une entrée de chargement $CH_{i,j}$ du compteur $C_{i,j}$ le chargement d'un nombre $NB_{i,j}$ dans ce compteur. Le nombre $NB_{i,j}$ est transmis par un bus de données BD, typiquement à 5 fils, qui est relié à cinq entrées de données du compteur $C_{i,j}$.

Les entrées de la porte $PD_{i,j}$ sont reliées respectivement à la sortie $41_j$ du décodeur 4L et à la sortie $42_i$ du décodeur 4C. Lorsque les entrées de la porte $PD_{i,j}$ passent à l'état "1", une entrée d'horloge $H_{i,j}$ du compteur $C_{i,j}$ reliée à la sortie de la porte $PD_{i,j}$ commande une décrémentation du nombre $NB_{i,j}$ d'une unité.

Le fonctionnement du circuit de gestion de nombre d'accès est maintenant décrit pendant un cycle qui correspond à une période d'horloge d'octet dans les voies multiplex entrantes et sortantes. Cette période d'octet au cours de laquelle un bloc de données peut être écrit en mémoire-tampon en fonction d'une adresse ade et un autre bloc de données peut être lu dans la mémoire-tampon en fonction d'une adresse ADL, est typiquement de l'ordre de quelques dizaines de nanosecondes.

Un cycle donné comprend le chargement du compteur $C_{i,j}$ d'une première cellule $1_{i,j}$ par un mot à 5 bits représentatif du nombre d'accès $NB_{i,j}$ égal au nombre de lectures à effectuer dans la cellule de données correspondant à l'adresse d'écriture ade = [ACS, ALS] sélectionnée au cours du cycle précédant le cyle donné. Le cycle donné comprend, simultanément au chargement, une décrémentation d'une unité du nombre mis à jour $NB_{p,q}$ du compteur $C_{p,q}$ d'une seconde cellule $1_{p,q}$ dans la matrice MC, en réponse à l'adresse de lecture ADL = [ALL, ACL] fournie au début du cycle donné et autorisant une lecture du bloc de données correspondant à l'adresse ADL dans la mémoire-tampon. Les indices p et q varient entre 0 et I-1 et entre 0 et J-1, avec $p \neq i$ et $q \neq j$; un bloc de données ne peut être simultanément écrit et lu en mémoire-tampon, puisque les voies multiplex sortantes sont balayées cycliquement par la base de temps (non représentée) du système de commutation, en l'occurence toutes les seize périodes d'octet. Enfin, après les chargement et décrémentation précédents correspondant à une mise à jour des compteurs de la matrice MC, le cycle donné comprend la recherche d'une cellule de comptage disponible afin d'établir une autre adresse d'écriture ade en correspondance de laquelle un bloc de données entrant sera écrit en mémoire-tampon pendant le cycle suivant le cycle donné.

Au début du cycle donné, simultanément à la réception du nombre $NB_{i,j}$ dans le bus de données BD, les premiers décodeurs 3L et 3C appliquent des états "1" aux sorties $31_j$ et $32_i$, validés par un signal de chargement fourni par la base de temps à la fin du cycle précédant le cycle donné comme on le verra dans la suite. Seule la porte $PCH_{i,j}$ de la cellule disponible $1_{i,j}$ dans la matrice MC a ses entrées $CHL_{i,j}$ et $CHC_{i,j}$ à l'état "1". Par suite, l'entrée $CH_{i,j}$ du compteur $C_{i,j}$ passe à l'état "1" pour charger ce compteur avec le nombre $NB_{i,j}$. La sortie $S_{i,j}$ du compteur $C_{i,j}$ passe de l'état "0" à l'état d'occupation "1".

Egalement au début du cycle donné, en réponse à des signaux de décrémentation fournis par la base de temps, les seconds décodeurs 4L et 4C recoivent simultanément les adresses de lecture ACL et ALL et les décodent. Les sorties de décodeur $41_q$ et $42_p$ sont à l'état "1". Seule la porte $PD_{p,q}$ de la cellule $1_{p,q}$ dans la matrice MC a ses entrées $DL_{p,q}$ et $DC_{p,q}$ à l'état "1". Par la suite, l'entrée d'horloge $H_{p,q}$ du compteur $C_{p,q}$ est à l'état "1" pour décrémenter d'une unité le nombre mis à jour $NB_{p,q}$ dans le compteur $C_{p,q}$. En pratique, comme on le verra dans la suite, une telle décrémentation consiste à modifier un mot codé représentatif du nombre $NB_{p,q}$. La sortie $S_{p,q}$ du compteur $C_{p,q}$ demeure à l'état d'occupation "0" lorsque le nombre $NB_{p,q}$ est encore plus grand ou égal à un, c'est-à-dire lorsque le bloc de données correspondant à l'adresse [ACL, ALL] = ADL en mémoire-tampon doit être encore diffusé vers des voies multiplex sortantes, ou la sortie $S_{p,q}$ passe à l'état de disponibilité "I" lorsque le bloc de données correspondant n'est pas à lire en mémoire-tampon.

A ce stade, il apparaît que toutes les cellules de comptage dans la matrice MC, y compris celles $1_{i,j}$ et $1_{p,q}$ ayant fait l'objet d'un chargement récent et d'une décrémentation récente, sont mis à jour. La recherche d'une cellule disponible peut alors débuter.

La recherche d'une cellule disponible est déclenchée par le premier signal de commande CL à l'état haut "1" qui est appliqué aux secondes entrées des portes NAND $PL_{O,O}$ à $PL_{I-1,J-1}$. Simultanément, le signal complémentaire $\overline{CL}$ est à l'état "0" et rend actif les transistors de charge $25_O$ à $25_{J-1}$. Grâce aux liaisons en OU câblé des sorties des portes $PL_{O,O}$ à $PL_{I-1,J-1}$, les entrées $21_O$ à $21_{J-1}$ de l'encodeur d'adresse de ligne 2L reproduisent l'état libre "1" d'au moins l'une des cellules dans chacune des lignes respectivement. L'encodeur 2L sélectionne prioritairement l'une des entrées $21_O$ à $21_{J-1}$ à l'état libre "1" ayant la plus petite adresse de ligne qui constitue l'adresse d'écriture de ligne sélectionnée ALS dans le bus de sortie 23.

Suite au passage à l'état "0" du signal CL déchargeant les entrées $21_O$ à $21_{J-1}$ et fermant les premières portes $PL_{O,O}$ à $PL_{I-1,J-1}$, le décodeur d'adresse de ligne 3L et les transistors $26_O$ à $26_{I-1}$ sont activés par le second signal de commande CC. Le décodeur 3L décode l'adresse sélectionnée ALS dans le bus 23 en appliquant l'état "1" à la sortie $31_{ALS}$ correspondant à l'adresse ALS. Les transistors de charge $26_O$ à $26_{I-1}$ active toutes les secondes portes NAND $PC_{O,O}$ à $PC_{I-1,J-1}$, mais seulement les secondes portes dans la ligne d'adresse ALS sont ouvertes par la sortie $31_{ALS}$. Il en résulte que, parmi les entrées $22_O$ à $22_{I-1}$ de l'encodeur d'adresse de colonne 2C, celles à l'état "1" correspondent à des cellules disponibles dans la ligne d'adresse ALS, et celles à l'état "0" correspondent à des cellules indisponibles dans la ligne d'adresse ALS. En effet, les sorties du décodeur 3L autres que $31_{ALS}$ sont à l'état "0" et maintiennent fermées les secondes portes NAND correspondantes.

L'encodeur 2C sélectionne alors prioritairement l'une des entrées $22_O$ à $22_{J-1}$ à l'état libre "1" ayant la plus petite adresse de colonne qui constitue l'adresse d'écriture de colonne sélectionnée ACS dans le bus de sortie 24.

Le couple d'adresses sélectionnées [ALS,ACS] constituant une adresse d'écriture ade est ainsi transmise à des registres d'écriture de la mémoire-tampon pour y écrire un bloc de données provenant d'une voie multiplex entrante, et à des files d'attente et une mémoire de commande incluses dans un circuit de commande et d'adresse en lecture du système de commutation afin de lire ultérieurement le bloc de données récemment écrit plusieurs fois en fonction du nombre d'accès $NB_{ALS,ACS}$ chargé dans la cellule sélectionnée $1_{ALS, ACS}$ au début du cycle suivant.

Comme déjà dit, au début du cycle suivant, en réponse au signal de chargement, l'adresse ACS appliquée par l'encodeur 2C via le bus 24 est décodée par le décodeur 3C afin que la sortie $42_{ACS}$ passe à l'état "1". Dans la matrice MC, seule la porte ET $PD_{ALS, ACS}$ à ses entrées à l'état "1", ce qui autorise le chargement du compteur $C_{ALS, ACS}$ avec

EP 0 506 577 B1

le nombre $NB_{ALS, ACS}$.

En référence à la Fig. 3, un compteur $C_{i,j}$ inclus dans une cellule de comptage $1_{i,j}$ comporte principalement cinq bascules "D" connectées en cascade 11, 12, 13, 14, 15, une porte OU-EXCLUSIF 16 et une porte ET 17.

Le compteur représenté est un compteur synchrone. Un même signal d'horloge qui peut être tantôt un signal de chargement délivré par la porte $PCH_{i,j}$, tantôt un signal de décrémentation délivré par la porte $PD_{i,j}$, est appliqué simultanément aux entrées d'horloge $H_1$ à $H_5$ des bascules 11 à 15 reliées aux bornes de compteur $CH_{i,j}$ et $H_{i,j}$. Les bascules 11 à 15 ont des entrées $D_1$ à $D_5$ reliées aux fils du bus de données BD.

Le compteur $C_{i,j}$ est également du type à séquence pseudoaléatoire. A cet effet, les sorties de deux bascules sont rebouclées sur l'entrée de la première bascule 11.

Selon la réalisation illustrée, la sortie $Q_5$ de la dernière bascule 15 et la sortie $Q_1$ de la première bascule 11 sont reliées respectivement aux entrées de la porte OU-EXCLUSIF 20 dont la sortie 30 est reliée à la sortie $D_1$ de la première bascule 11. La porte ET 17 possède, selon la réalisation illustrée, trois entrées reliées respectivement aux sorties $Q_3$, $Q_4$ et $Q_5$ des bascules 13, 14 et 15. La sortie de la porte 17 constitue la sortie $S_{i,j}$ du compteur qui est à l'état "1" si les trois sorties $Q_3$, $Q_4$, $Q_5$ sont à l'état "1", et à l'état "0" si au moins l'une des trois sorties $Q_3$, $Q_4$, $Q_5$ est à l'état "0".

Le choix d'un compteur synchrone à séquence pseudoaléatoire pour chaque cellule de la matrice de comptage MC selon l'invention est lié notamment à des exigences de vitesse de fonctionnement.

En effet, dans un compteur asynchrone, l'entrée d'horloge d'une bascule est reliée à la sortie de la bascule précédente, et ainsi un retard est engendré entre deux entrées d'horloge des deux bascules successives, le retard correspondant au temps de basculement de la bascule précédente. Le comptage ou décomptage est donc plus rapide dans des compteurs synchrones.

Pour charger le compteur $C_{i,j}$, l'état "1" est appliqué à l'entrée $CH_{i,j}$ et simultanément les bits du mot codé $NB_{i,j}$ dans le bus BD sont appliqués aux entrées $D_1$ à $D_5$ des bascules afin que les sorties Q1 à Q5 mémorisent les états des cinq bits du mot $NB_{i,j}$.

Le mot chargé à 5 bits est représentatif du nombre de lectures $NB_{i,j}$ à réaliser et n'est pas issu d'un codage binaire du nombre $NB_{i,j}$ comme on le verra dans la suite.

Afin de décrémenter le nombre $NB_{i,j}$ et modifier en conséquence le mot codé à 5 bits correspondant selon une séquence pseudoaléatoire, une impulsion d'horloge "1" est appliqué à l'entrée $H_{i,j}$ du compteur $C_{i,j}$ et par suite à toutes les entrées d'horloge $H_1$ à $H_5$ des bascules 11 à 15. En réponse à l'impulsion d'horloge, les quatre bascules 12, 13, 14 et 15 génèrent les états des sorties $Q_1$, $Q_2$, $Q_3$, $Q_4$ précédant l'impulsion, respectivement. La première bascule 11 génère en sortie $Q_1$ l'état à la sortie de la porte OU-EXCLUSIF 16 dépendant des états aux sorties $Q_5$ et $Q_1$ des bascules 15 et 11 précédant l'impulsion.

Des décrémentations successives dans la cellule de comptage $1_{i,j}$ produisent des mots successifs d'une partie ou de la totalité d'une séquence pseudoaléatoire aux sorties $Q_1$, $Q_2$, $Q_3$, $Q_4$, $Q_5$ dans le compteur $C_{i,j}$. Par exemple, en supposant que les nombres d'accès $NB_{i,j}$ ne peuvent être supérieur à un nombre maximal égal à 18, les décrémentations de ce nombre maximum produisent la séquence de mots codés [$Q_1$, $Q_2$, $Q_3$, $Q_4$, $Q_5$] suivante :

| $NB_{i,j}$ = Nombre de lecture ou d'accès | $Q_1$ | $Q_2$ | $Q_3$ | $Q_4$ | $Q_5$ |
|---|---|---|---|---|---|
| 18 | 0 | 1 | 0 | 1 | 1 |
| 17 | 1 | 0 | 1 | 0 | 1 |
| 16 | 0 | 1 | 0 | 1 | 0 |
| 15 | 0 | 0 | 1 | 0 | 1 |
| 14 | 1 | 0 | 0 | 1 | 0 |
| 13 | 1 | 1 | 0 | 0 | 1 |
| 12 | 0 | 1 | 1 | 0 | 0 |
| 11 | 0 | 0 | 1 | 1 | 0 |
| 10 | 0 | 0 | 0 | 1 | 1 |
| 9 | 1 | 0 | 0 | 0 | 1 |
| 8 | 0 | 1 | 0 | 0 | 0 |
| 7 | 0 | 0 | 1 | 0 | 0 |
| 6 | 0 | 0 | 0 | 1 | 0 |
| 5 | 0 | 0 | 0 | 0 | 1 |
| 4 | 1 | 0 | 0 | 0 | 0 |
| 3 | 1 | 1 | 0 | 0 | 0 |
| 2 | 1 | 1 | 1 | 0 | 0 |
| 1 | 1 | 1 | 1 | 1 | 0 |

(suite)

| $NB_{i,j}$ = Nombre de lecture ou d'accès | $Q_1$ | $Q_2$ | $Q_3$ | $Q_4$ | $Q_5$ |
|---|---|---|---|---|---|
| 0 | 1 | 1 | 1 | 1 | 1 |

Selon d'autres exemples, si le nombre $NB_{i,j}$ est égal à 13 ou 6, une séquence ne débute que par le chargement du mot codé "11001" ou "00010".

Le rebouclage consistant à relier les sorties $Q_5$ et $Q_1$ de la dernière bascule 15 et de la première bascule 11 à l'entrée $D_1$ de la première bascule 11 à travers la porte OU-EXCLUSIF 16 permet de générer une séquence plus longue qu'une séquence générée sans rebouclage. En effet, sans rebouclage, le compteur est similaire à un registre à décalage et le nombre maximum des états aux sorties $Q_1$ à $Q_5$ est limité à cinq ce qui correspond à un nombre d'accès en pratique insuffisant dans le cadre de la commutation temporelle de paquets.

De même, un seul rebouclage, formé par exemple par la liaison de la sortie $Q_5$ à l'entrée $D_1$, n'autorise qu'une séquence cyclique répétitive ne comprenant que cinq états successifs différents.

Le compteur $C_{i,j}$ selon l'invention ne réalise pas un décomptage en code binaire "pur" et est choisi ainsi pour des raisons de coût et de compacité. En effet, la réalisation d'un compteur binaire "pur" nécessite l'adjonction de portes logiques supplémentaires qui accroissent la taille du circuit intégré. La réduction du coût de la matrice de cellules de comptage selon l'invention est d'autant plus prononcée que le nombre de compteurs $C_{O,O}$ à $C_{I-1,J-1}$, typiquement égal à 512, est élevé.

Dans un système de commutation temporelle incluant le circuit de gestion, le nombre de lecture des cellules de données n'est limité qu'à dix-huit selon l'exemple précédent, autorisant ainsi une diffusion multipoint d'un bloc de données limitée à dix-huit voies multiplex sortantes.

La porte de sortie ET 17 constitue un moyen pour signaler l'état libre ou occupé de la cellule de données correspondante à la cellule de comptage $1_{i,j}$ selon que le nombre mis à jour $NB_{i,j}$ est égal ou différent de zéro. La sortie $S_{i,j}$ de la porte 17 est à l'état "1" pour indiquer que la cellule de données correspondante à la cellule de comptage $1_{i,j}$ est libre et peut donc être adressée en écriture. Les états des trois dernières sorties de bascule $Q_3$, $Q_4$ et $Q_5$ sont alors à l'état "1".

En référence aux mots codés $[Q_1, Q_2, Q_3, Q_4, Q_5]$ de la séquence précédemment décrite, seul le mot binaire "11111" implique l'état "1" à la sortie $S_{i,j}$ et indique 1' inoccupation de la cellule.

Dans le cas où le nombre $NB_{i,j}$ n'est pas fourni directement sous la forme de l'un des mots codés $[Q_1, Q_2, Q_3, Q_4, Q_5]$ à la matrice MC, le bus BD est précédé d'un moyen de codage approprié. Par exemple, lorsque le nombre $NB_{i,j}$ est sous la forme d'un mot binaire dénoté nbms pour paquet synchrone ou nbma pour paquet asynchrone dans la EP-A-0300876, le moyen de codage code un mot nbms, nbma issu du codage binaire de $NB_{i,j}$, ou un mot nbms, nbma ne comprenant qu'un seul bit à l'état "1" ayant un emplacement fonction de $NB_{i,j}$, en le mot codé correspondant.

Ainsi, dans le cadre d'un système de commutation selon la EP-A-0300876, un circuit de gestion de nombres d'accès selon l'invention remplit les fonctions effectuées principalement par les éléments repérés MLC, DEC, TZ et MAD, inclus dans le circuit de gestion de mémoire-tampon et d'adressage en écriture CAE montré à la Fig.6 de la EP-A-0300876.

Par ailleurs les mots "ligne" et "colonne" dans la présente description et dans l'objet de la présente demande de brevet définies ci-après peuvent être remplacés par"colonne"et"ligne"respectivement, sans modifier le principe du fonctionnement du circuit de gestion des nombres d'accès.

## Revendications

1. Circuit de gestion de nombres d'accès à des ressources logiques pour établir des adresses d'écriture (ade) de ressources disponibles dans un ensemble de ressources logiques en fonction des nombres d'accès ($NB_{O,O}$ à $NB_{I-1, J-1}$) mis à jour, le nombre d'accès attribué à une ressource logique étant décrémenté d'une unité en réponse à une adresse de lecture (ADL) de ladite ressource, ledit circuit de gestion comprenant:

   - une matrice (MC) incluant des cellules de comptage ($1_{O,O}$ à $1_{I-1,J-1}$) qui mémorisent respectivement les nombres d'accès mis à jour des ressources de l'ensemble, chaque cellule de comptage étant respectivement assignée à une ressource logique,
   - des moyens de sélection de cellule (2L,2C,3L,3C) pour sélectionner l'une ($C_{ALS,ACS}$) des cellules de comptage contenant des nombres d'accès égaux à zéro afin d'établir l'adresse d'écriture (ade) de la ressource disponible associée à la cellule sélectionnée ($C_{ALS,ACS}$) et charger un nombre d'accès ($NB_{ALS,ACS}$) de la ressource disponible dans la cellule sélectionnée ($C_{ALS,ACS}$) et

- des moyens de décodage d'adresse de lecture de ressource (4L,4C) pour décrémenter d'une unité les nombres d'accès ($NB_{p,q}$) différents de zéro dans des cellules de comptage en réponse aux adresses de lecture de ressource (ADL) respectivement.

2. Circuit conforme à la revendication 1, caractérisé en ce que les moyens de sélection de cellule comprennent des premiers moyens (2L,3L) pour sélectionner parmi toutes les lignes ($21_O$ à $21_{J-1}$) de la matrice (MC) des lignes de matrice ayant chacune au moins une cellule de comptage contenant un nombre d'accès égal à zéro afin d'établir l'adresse (ALS) de l'une des lignes sélectionnée, et des seconds moyens pour sélectionner parmi toutes les colonnes ($22_O$ à $22_{I-1}$) de la matrice (MC), des colonnes de la matrice comprenant des cellules de comptage qui contiennent des nombres d'accès égaux à zéro et qui sont incluses dans la ligne sélectionnée dont l'adresse est établie afin d'établir l'adresse (ACS) de l'une des colonnes sélectionnées et charger un nombre d'accès dans la cellule de comptage correspondant aux adresses établies (ALS, ACS) de la ligne sélectionnée et de la colonne sélectionnée.

3. Circuit conforme à la revendication 1, caractérisé en ce que les moyens de sélection de cellule comprennent

- des premiers moyens d'encodage d'adresse d'écriture (2L) pour sélectionner parmi toutes les lignes ($21_0$ à $21_{J-1}$) de la matrice (MC), des lignes de matrice ayant chacune au moins une cellule de comptage contenant un nombre d'accès égal à zéro afin d'établir l'adresse (ALS) de l'une ($22_i$) des lignes sélectionnées,
- des premiers moyens de décodage d'adresse d'écriture (3L) pour préparer le chargement des cellules de comptage ($C_{i,O}$ à $C_{i,J-1}$) dans la ligne sélectionnée ($22_i$) dont l'adresse est établie,
- des seconds moyens d'encodage d'adresse d'écriture (2C) pour sélectionner parmi toutes les colonnes ($22_O$ à $22_{I-1}$) de la matrice (MC), des colonnes de matrice contenant des cellules de comptage qui contiennent des nombres d'accès égaux à zéro et qui sont prêtes à être chargées afin d'établir l'adresse (ACS) de l'une des colonnes sélectionnées,
- des seconds moyens de décodage d'adresse d'écriture (3C) pour charger un nombre d'accès dans la cellule de comptage incluse dans les ligne et colonne sélectionnées dont les adresses sont établies.

4. Circuit conforme à la revendication 3, caractérisé en ce que les adresses établies de ligne et colonne (ALS,ACS) sont les plus petites parmi des adresses des lignes sélectionnées et les adresses des colonnes sélectionnées respectivement.

5. Circuit conforme à la revendication 3 ou 4, caractérisé en ce que chaque cellule de comptage ($1_{i,j}$) comprend des moyens ($PL_{i,j}$) pour signaler un nombre d'accès égal à zéro ($NB_{i,j}$) contenu dans ladite cellule à une entrée ($21_j$) des premiers moyens d'encodage (2L) qui est commune aux cellules de comptage ($1_{O,j}$ à $1_{I-1,j}$) contenues dans la ligne de la matrice (MC) correspondant à ladite cellule, en réponse à un premier signal de commande (CL), et des moyens ($PC_{i,j}$) pour signaler ledit nombre d'accès nul ($NB_{i,j}$) à une entrée ($22_i$) des seconds moyens d'encodage (2C) qui est commune aux cellules de comptage ($1_{i,O}$ à $1_{i,J-1}$) dans la colonne de la matrice (MC) correspondant à ladite cellule, en réponse à la préparation du chargement des cellules dans ladite ligne ($21_j$) par les premiers moyens de décodage (3L) et à un second signal de commande (CC).

6. Circuit conforme à l'une quelconque des revendications 1 à 5, caractérisé en ce que les moyens de décodage d'adresse de lecture comprennent des moyens (2L) pour préparer la décrémentation des cellules de comptage ($1_{p,O}$ à $1_{p-I-1}$) dans une ligne (41p) de la matrice (MC) en réponse à une adresse de ligne (ALL) incluse dans une adresse de lecture (ADL), et des moyens pour décrémenter d'une unité une cellule de comptage préparée ($1_{p,q}$) en réponse à une adresse de colonne (ACL) incluse dans l'adresse de lecture (ADL), la décrémentation de ladite cellule de comptage ($C_{p,q}$) étant de préférence simultanée au chargement de nombre d'accès dans une autre cellule de comptage ($1_{i,j}$) par les moyens de sélection de cellule (2L,2C,3L,3C).

7. Circuit de gestion de nombres d'accès à des ressources logiques conforme à l'une quelconque des revendications 1 à 6, caractérisé en ce que chacune desdites cellules de comptage ($1_{i,j}$) comprend un compteur synchrone à séquence pseudoaléatoire ($C_{i,j}$).

8. Circuit de gestion de nombres d'accès à des ressources logiques conforme à la revendication 7, caractérisé en ce que ladite séquence est composée de mots codés ($Q_1$, $Q_2$, $Q_3$, $Q_4$, $Q_5$) respectivement associés à des nombres d'accès décroissants différents ($NB_{O,O}$ à $NB_{I-1,J-1}$) inférieurs à un nombre maximal (18), et en ce que le compteur comprend, en sortie, un moyen (17) pour signaler aux moyens de sélection de cellule (2L,2C,3L,3C) un nombre d'accès nul ($NB_{i,j}$) contenu dans la cellule lorsque le dernier mot de la séquence est contenu dans le compteur.

**Patentansprüche**

1. Schaltung zur Verwaltung von Zahlen von Zugriffen auf logische Quellen zum Aufstellen von Schreibadressen (ade) freier Quellen in einer Gesamtheit logischer Quellen in Abhängigkeit von den aktualisierten Zugriffszahlen ($NB_{0,0}$ bis $NB_{I-1,J-1}$), wobei die Zugriffszahl, die einer logischen Quelle zugeordnet ist, in Antwort auf eine Leseadresse (ADL) dieser Quelle um Eins dekrementiert wird, wobei diese Verwaltungsschaltung umfaßt:

   - eine Matrize (MC) von Zählerzellen ($1_{0,0}$ bis $1_{I-1,J-1}$), die jeweils die aktualisierten Zugriffszahlen der Quellen der Gesamtheit speichern, wobei jede Zählerzelle jeweils einer logischen Quelle zugeordnet ist,
   - Mittel zur Zellenauswahl (2L, 2C, 3L, 3C) zum Auswählen einer ($C_{ALS,ACS}$) der Zählerzellen, die eine Zugriffszahl gleich Null enthalten, um die Schreibadresse (ade) der freien Quelle aufzustellen, die der ausgewählten Zelle ($C_{ALS,ACS}$) zugeordnet ist und eine Zahl der Zugriffe ($NB_{ALS,ACS}$) auf die freie Quelle in die ausgewählte Zelle ($C_{ALS,ACS}$) zu laden, und
   - Mittel zum Dekodieren der Leseadresse einer Quelle (4L,4C), um die Zugriffszahlen ($Nb_{p,q}$) ungleich Null in Zählerzellen jeweils in Antwort auf die Quellenleseadressen (ADL) um Eins zu dekrementieren.

2. Schaltung nach Patentanspruch 1, dadurch gekennzeichnet, daß die Mittel zur Zellenauswahl erste Mittel (2L, 3L) enthalten, um aus allen Zeilen ($21_0$ bis $21_{J-1}$) der Matrize (MC) Matrizenzeilen auszuwählen, die jeweils mindestens eine Zählerzelle aufweisen, die eine Zugriffszahl gleich Null enthalten, um die Adresse (ALS) einer der ausgewählten Zeilen aufzustellen, und zweite Mittel, um unter allen Spalten ($22_0$, $22_{I-1}$) der Matrize (MC) Matrizenspalten auszuwählen, die Zählerzellen enthalten, die Zugriffszahlen gleich Null enthalten, und die in der ausgewählten Zeile enthalten sind, deren Adresse aufgestellt wurde, um die Adresse (ACS) einer der ausgewählten Spalten aufzustellen und eine Zugriffszahl in die Zählerzelle zu laden, die den aufgestellten Adressen (ALS, ACS) der ausgewählten Zeile und der ausgewählten Spalte entspricht.

3. Schaltung nach Patentanspruch 1, dadurch gekennzeichnet, daß die Mittel zur Zellenauswahl umfassen

   - erste Mittel zur Kodierung von Schreibadressen (2L), um unter allen Zeilen ($21_0$ bis $21_{J-1}$) der Matrize (MC) Matrizenzeilen auszuwählen, die jeweils mindestens eine Zählerzelle aufweisen, die eine Zugriffszahl gleich Null enthalten, um die Adresse (ALS) einer (22i) der ausgewählten Zeilen aufzustellen,
   - erste Mittel zur Dekodierung von Schreibadressen (3L), um das Laden der Zählerzellen ($C_{i,0}$ bis $Ci,_{J-1}$) in der ausgewählten Zeile ($22_i$) vorzubereiten, deren Adresse aufgestellt wurde,
   - zweite Mittel zur Kodierung einer Schreibadresse (2C), um unter allen Spalten ($22_0$, $22_{i-1}$) der Matrize (MC) Matrizenspalten auszuwählen, die Zählerzellen enthalten, die Zugriffszahlen gleich Null enthalten, und die bereit sind, geladen zu werden, um die Adresse (ACS) einer der ausgewählten Spalten aufzustellen,
   - zweite Mittel zum Dekodieren der Schreibadresse (3C) um eine Zugriffszahl in die Zählerzelle zu laden, die in der ausgewählten Zeile und Spalte enthalten ist, deren Adressen aufgestellt wurden.

4. Schaltung nach Patentanspruch 3, dadurch gekennzeichnet, daß die aufgestellten Adressen der Zeile und der Spalte (ALS, ACS) die kleinsten unter den Adressen der ausgewählten Zeilen bzw. den Adressen der ausgewählten Spalten sind.

5. Schaltung nach Patentanspruch 3 oder 4, dadurch gekennzeichnet, daß jede Zählerzelle ($1_{i,j}$) Mittel ($PL_{i,j}$) aufweist, um eine Zugriffszahl gleich Null ($NB_{i,j}$) in dieser Zelle einem Eingang ($21_j$) der ersten Kodiermittel (2L) zu melden, der den Zählerzellen ($1_{0,j}$ bis $1_{I-1,j}$) gemeinsam ist, die sich in der Zeile der Matrize (MC) befinden, die der genannten Zelle entspricht, und zwar in Antwort auf ein erstes Steuersignal (CL), und Mittel ($PC_{i,j}$), um die Zugriffszahl gleich Null ($NB_{I,j}$) einem Eingang ($22_i$) der zweiten Kodiermittel (2C) zu melden, der den Zählerzellen ($1_{i,0}$ bis $1_{i,J-1}$) in der Spalte der Matrize (MC) gemeinsam ist, die der genannten Zelle entspricht, in Antwort auf die Vorbereitung der Ladung der Zellen in der genannten Zeile ($21_j$) durch die ersten Dekodiermittel (3L) und auf ein zweites Steuersignal (CC).

6. Schaltung nach irgendeinem der Patentansprüche 1 bis 5, dadurch gekennzeichnet, daß die Mittel zum Dekodieren von Leseadressen Mittel (2L) enthalten, um die Dekrementierung der Zählerzellen ($1_{p,0}$ bis $1_{p,I-1}$) in einer Zeile (41p) der Matrize (MC) in Antwort auf eine Zeilenadresse (ALL) vorzubereiten, die in einer Leseadresse (ADL) enthalten ist, und Mittel zum Dekrementieren einer vorbereiteten Zählerzelle ($1_{p,q}$) um Eins in Antwort auf eine Spaltenadresse (ACL), die in der Leseadresse (ADL) enthalten ist, wobei die Dekrementierung dieser Zählerzelle ($C_{p,q}$) vorzugsweise gleichzeitig mit dem Laden der Zugriffszahl in eine andere Zählerzelle ($1_{i,j}$) durch die Zellenauswahlmittel (2L, 2C, 3L, 3C) erfolgt.

7. Schaltung zur Verwaltung von Zahlen von Zugriffen auf logische Quellen nach irgendeinem der Patentansprüche 1 bis 6, dadurch gekennzeichnet, daß jede der genannten Zählerzellen ($1_{i,j}$) einen Synchronzähler mit Pseudozufallsfolge ($C_{i,j}$) umfaßt.

8. Schaltung zur Verwaltung von Zahlen von Zugriffen auf logische Quellen nach Patentanspruch 7, dadurch gekennzeichnet, daß die genannte Folge aus kodierten Wörtern ($Q_1$, $Q_2$, $Q_3$, $Q_4$, $Q_5$) besteht, die jeweils verschiedenen abnehmenden Zugriffszahlen ($NB_{0,0}$ bis $NB_{I-1,J-1}$) entsprechen, die geringer sind, als eine Maximalzahl (18), und dadurch, daß der Zähler am Ausgang ein Mittel (17) enthält, um den Zellenauswahlmitteln (2L, 2C, 3L, 3C) eine Zugriffszahl gleich Null ($NB_{i,j}$) zu melden, die sich in der Zelle befindet, wenn sich das letzte Wort der Folge im Zähler befindet.

## Claims

1. Circuit managing numbers of accesses to logic resources thereby deriving write-in addresses (ade) of available resources in a set of logic resources contingent on updated numbers of accesses ($NB_{0,0}$ to $NB_{I-1, J-1}$), the number of accesses attributed to a logic resource being decremented by one unity in response to a read-out address (ADL) of said resource, said managing circuit comprising:

   - a matrix (MC) including counting cells ($1_{0,0}$ to $1_{I-1,J-1}$) which respectively store the updated access numbers of the ressources of the set, each counting cell being respectively assigned to a logic resource,
   - cell selection means (2L, 2C, 3L, 3C) for selecting one ($C_{ALS,ACS}$) of the counting cells containing access numbers equal to zero thereby deriving the write-in address (ade) of the available resource associated to the selected cell ($C_{ALS,ACS}$) and loading an access number ($NB_{ALS,ACS}$) of the available resource into the cell selected ($C_{ALS,ACS}$), and
   - resource read-out address decoding means (4L,4C) for decrementing by one unity the access numbers ($NB_{p,q}$) different from zero in the counting cells in response to the resource read-out addresses (ADL) respectively.

2. Circuit according to claim 1, characterized in that the cell selection means comprise first means (2L,3L) for selecting amongst all the rows ($21_0$ to $21_{J-1}$) of the matrix (MC), matrix rows each having at least one counting cell containing an access number equal to zero thereby deriving the address (ALS) of one of the selected rows, and second means for selecting amongst all the columns ($22_0$ to $22_{I-1}$) of the matrix (MC), matrix columns comprising counting cells which contain access numbers equal to zero and which are included in the selected row whose address is derived thereby deriving the address (ACS) of one of the selected columns and loading an access number in the counting cell corresponding to the derived addresses (ALS, ACS) of the selected line and selected column.

3. Circuit according to claim 1, characterized in that the cell selection means comprise

   - first write-in address encoding means (2L) for selecting amongst all the rows ($21_0$ to $21_{J-1}$) of the matrix (MC), matrix rows each having at least one counting cell containing an access number equal to zero thereby deriving the address (ALS) of one ($22_i$) of the selected rows,
   - first write-in address decoding means (3L) for preparing the loading of the counting cells ($C_{i,0}$ to $C_{i,J-1}$) in the selected row ($22_i$) whose address is derived,
   - second write-in address encoding means (2C) for selecting amongst all the columns ($22_0$ to $22_{I-1}$) of the matrix (MC), matrix columns containing counting cells which contain access numbers equal to zero and which are prepared to be loaded thereby deriving the address (ACS) of one of the selected columns,
   - second write-in address decoding means (3C) for loading an access number in the counting cell included in the selected row and column whose addresses are derived.

4. Circuit according to claim 3, characterized in that the derived row and column addresses (ALS,ACS) are the smallest amongst the addresses of the selected rows and the addresses of the selected columns respectively.

5. Circuit according to claim 3 or 4, characterized in that each counting cell ($1_{i,j}$) comprises means ($PL_{i,j}$) for signalling an access number equal to zero ($NB_{i,j}$) contained in said cell to an input ($21_j$) of the first encoding means (2L) which is common to the counting cells ($1_{0,j}$ to $1_{I-1,j}$) contained in the row of the matrix (MC) corresponding to said cell, in response to a first control signal (CL), and means ($PC_{i,j}$) for signalling said zero access number ($NB_{i,j}$) to an input ($22_i$) of the second encoding means (2C) which is common to the counting cells ($1_{i,0}$ to $1_{i,J-1}$) in the column of the matrix (MC) corresponding to said cell, in response to the loading preparation of the cells in said row ($22_i$)

**EP 0 506 577 B1**

by the first decoding means (3L) and to a second control signal (CC).

6. Circuit according to any one of claims 1 to 5, characterized in that the read-out address decoding means comprise means (2L) for preparing the decrementation of the counting cells ($1_{p,0}$ to $1_{p,I-1}$) in a row ($41_p$) of the matrix (MC) in response to a row address (ALL) included in a read-out address (ADL), and means for decrementing by one unity a prepared counting cell ($I_{p,q}$) in response to a column address (ACL) included in the read-out address (ADL), the decrementation of said counting cell ($C_{p,q}$) being preferably simultaneous to the access number loading in another counting cell ($1_{i,j}$) by the cell selection means (2L,2C,3L,3C).

7. Circuit managing numbers of accesses to logic resources according to any one of claims 1 to 6, characterized in that each of said counting cells ($I_{i,j}$) comprises a pseudo-random sequence synchronous counter ($C_{i,j}$).

8. Circuit managing numbers of accesses to logic resources according to claim 7, characterized in that said sequence is composed of encoded words ($Q_1$, $Q_2$, $Q_3$, $Q_4$, $Q_5$) respectively associated to different decreasing access numbers ($NB_{0,0}$ to $NB_{I-1,J-1}$) less than a maximum number (18), and in that the counter comprises, on output side, a means (17) for signalling a zero access number ($NB_{i,j}$) contained in the cell to the cell selecting means (2L,2C;3L,3C) when the last word of the sequence is contained in the counter.

FIG.1

## FIG. 2

## FIG. 3